# EUROPÄISCHE PATENTSCHRIFT

(11) **EP 2 992 122 B1**
(45) Veröffentlichungstag und Bekanntmachung des Hinweises auf die Patenterteilung: **22.03.2017**
(21) Anmeldenummer: 14728823.7
(22) Anmeldetag: 24.04.2014
(51) Int. Cl.: C23C 14/50, C23C 14/04, B23B 29/04, H01J 37/32

(54) **VIELSEITIGE HALTEVORRICHTUNG ZUR OBERFLÄCHENBEHANDLUNG VON STANGENFÖRMIGEN SUBSTRATEN**
VERSATILE HOLDER FOR TREATING THE SURFACE OF ROD-SHAPED SUBSTRATES
DISPOSITIF DE RETENUE À PLUSIEURS FACES POUR LE TRAITEMENT DE SURFACE DE SUBSTRATS EN FORME DE BARRE

(30) Priorität: 02.05.2013 DE 102013007454
(43) Veröffentlichungstag der Anmeldung: 09.03.2016
(73) Patentinhaber: Oerlikon Surface Solutions AG, Pfäffikon, 8808 Pfäffikon (CH)
(72) Erfinder: SIEBERT, Max, 67292 Kirchheimbolanden (DE); VOGEL, Remo, 9470 Buchs SG (DE); JOTZ, Karl Wolfgang, 91626 Schopfloch (DE)
(74) Vertreter: Troesch Scheidegger Werner AG
(86) Internationale Anmeldenummer: PCT/EP2014/001091
(87) Internationale Veröffentlichungsnummer: WO 2014/177254

(56) Entgegenhaltungen:
- DE-A1-102005 003 047
- DE-A1-102011 050 451
- JP-A- 2008 260 973
- US-A- 4 528 208
- US-A1- 2007 104 871

## Beschreibung

Die vorliegende Erfindung betrifft eine Haltevorrichtung zur Oberflächenbehandlung von stangenförmigen Substraten. Eine Haltevorrichtung gemäss der vorliegenden Erfindung ist insbesondere für die Oberflächenbehandlung von Schneidwerkzeugen der Sorte Stabmesser sehr gut geeignet.

### Stand der Technik

Oberflächen von vielen Gegenständen werden heutzutage behandelt, um gewisse Eigenschaften an der Oberfläche zu erreichen.

Oberflächen von Bauteilen und Werkzeugen werden heutzutage oft durch Beschichtungen erheblich für besondere Anwendungen verbessert.

Dabei spielt die Auswahl der richtigen Substrathalterung bei jedem Oberflächenbehandlungsprozess eine sehr wichtige Rolle. Deshalb werden zweckmässige Substrathalterungen für spezifische Oberflächenbehandlungsprozesse entwickelt, die die Art der zu behandelnden Substratoberfläche berücksichtigen, sowie auch weitere Substrateigenschaften (wie zum Beispiel Substratform, -dimensionen und -zusammensetzung).

Eine heutzutage übliche Oberflächenbehandlung von Substraten ist das Beschichten. Dabei werden Schichten mit besonderen Eigenschaften auf bestimmte Substratoberflächen aufgetragen. Durch die Beschichtung werden den Substratoberflächen verbesserte Eigenschaften verliehen, welche die Verwendung dieser Substrate bei bestimmten Anwendungen oder eine Leistungserhöhung dieser Substrate bei einer bestimmten Anwendung ermöglichen.

Beispielsweise werden bei Schneidwerkzeugen üblicherweise die Schneidflächen (zumindest teilweise) mit Verschleissschutzschichten beschichtet, um die Schneidleistung dieser Werkzeuge zu erhöhen.

Dafür werden spezielle Substrathaltevorrichtungen entwickelt.

Beispielweise offenbart das Patentdokument DE60002579T2 eine hohle Substrathalterung, die zum Tragen eines Bohrsatzes für das Ablagern einer Keramikbeschichtung auf Bereiche der Bohrer, die sich von deren Spitzen aus erstrecken, verwendet wird. Diese Substrathalterung umfasst:
- zumindest eine perforierte Aussenwand, die mit einer Anordnung von Öffnungen versehen ist, in die die Bohrer so eingesetzt werden, dass die vorgenannte Bereiche aus der Halterung herausragen,
- eine Stützwand innerhalb des hohlen Innenraums der Halterung für die oder für jede perforierte Aussenwand parallel zur Aussenwand und von dieser beanstandet und mit einer entsprechenden Anordnung von Öffnungen versehen, um die eingesetzten Bohrer mit ihren Schäften im Wesentlichen parallel anzuordnen,
- ein Anschlagmittel innerhalb des hohlen Innenraums der Halterung, das von der oder jeder Stützwand nach innen beanstandet ist, um die Spitzen von Bohrern mit dem gleichen Durchmesser zu positionieren, die im Wesentlichen im gleichen Ausmass aus der Aussenwand vorrangen, wobei der hohle Innenraum der Halterung und die Positionierung der Bohrer derart sind, dass der Teil eines jeden Bohrers innerhalb der Aussenwand von der äusseren Umgebung abgeschirmt ist, aber der Atmosphäre im Innenraum der Halterung ausgesetzt ist.

Die oben erwähnte Halterung hat jedoch den Nachteil, dass sie an Vielseitigkeit mangelt und deswegen nicht für die Beschichtung von verschiedenen Sorten von stangenförmigen Substraten gleichzeitig angewendet werden kann, sondern nur für die Beschichtung von Substraten (in diesem Fall von Bohrern), die im Wesentlichen gleiche Länge und gleichen Durchmesser ausweisen.

Weitere Substrathalter werden in den Patentschriften DE102011050451 A1 und US2007/104871 A1 offenbart.

### Aufgabe der vorliegenden Erfindung

Es ist Aufgabe der vorliegenden Erfindung eine vielseitige Haltevorrichtung für die Oberflächenbehandlung von stangenförmigen Substraten mit zumindest zwei Bereichen mit unterschiedlichem Querschnitt, wobei einer von diesen Bereichen ein Ende mit einem Querschnitt kleiner als der Querschnitt des zumindest anderen Bereichs umfasst. Die Halterung muss ermöglichen, dass zumindest das Ende mit kleinerem Querschnitt unabhängig von der gesamten Substratlänge in der gleichen Weise beschichtet werden kann.

Die Haltevorrichtung gemäss der vorliegenden Erfindung soll ausserdem ermöglichen, dass die in der Haltevorrichtung befestigten stangenförmigen Substrate mehreren Oberflächenbehandlungsprozessen unterzogen werden können, ohne dass die Substrate aus der Haltevorrichtung entladen und danach in die gleiche oder in eine andere Haltevorrichtung wiederbeladen werden müssen.Dadurch wird der Handhabungsaufwand und das Risiko, die Substrate zu beschädigen, reduziert. Insbesondere soll eine Haltevorrichtung gemäss der vorliegenden Erfindung, die Reinigung, Vorbehandlung, Beschichtung und Nachbehandlung von Stabmessern gemäss den Anwendungsanforderungen ermöglichen.

### Beschreibung der vorliegenden Erfindung

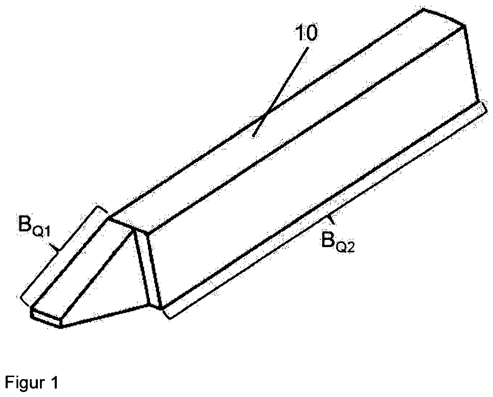

Die Figuren 1 bis 9 sollen als Beitrag zum besseren Verständnis und nicht zur Beschränkung der vorliegenden Erfindung dienen:
- Figur 1: Substratkörper 10 mit einer zu behandelnden Oberfläche im Substratkörperbereich B_{Q1} und einer nicht zu behandelnden Oberfläche im Substratkörperbereich B_{Q2}.

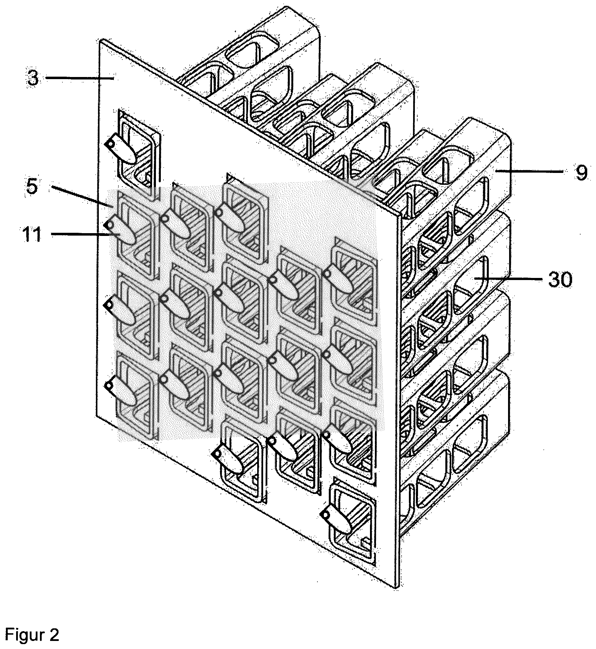

- Figur 2: Haltevorrichtung gemäss einer Ausführungsform der vorliegenden Erfindung mit einer Anordnung von Stützelementen 9 zur Annahme von stangenförmigen Substratkörpern, wobei die die Stützelemente 9 an einer Frontwand 3 mit einer Anordnung von Öffnungen (5) befestigt sind, so dass an jeder Öffnung 5 ein Stützelement 9 befestigt ist, und wobei an jeder Öffnung 5 ein Anhaltelement 11 zum Anhalten des Substratkörpers vorhanden ist. Die in der Figur 2 gezeichneten Stützelemente sind beispielsweise Rechteckige Profile mit Ausnahmen 30, welche einer Reinigung der Substratkörper 10 (in der Figur 2 nicht dargestellt) bei einem Reinigungsprozesses erleichtern sollten.

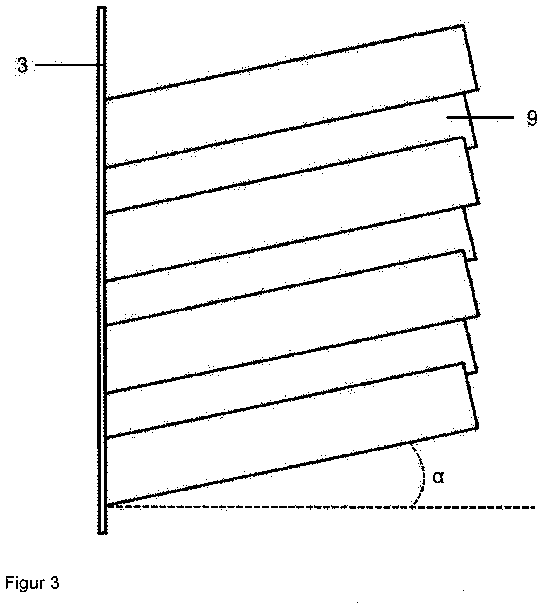

- Figur 3: Anordnung von Stützelementen 9, bei der die Stützelemente 9 mit einer Neigungswinkel α zur Horizontalen und in der Vertikalebene parallel angeordnet sind.

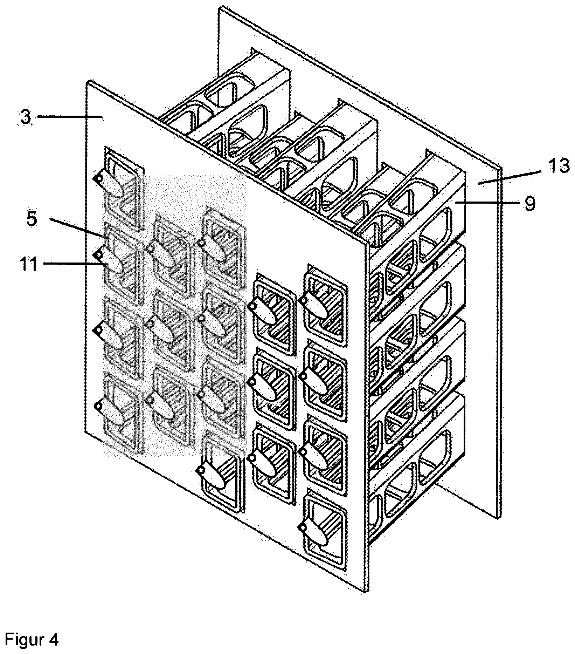

- Figur 4: Haltevorrichtung gemäss einer Ausführungsform der vorliegenden Erfindung mit einer zusätzlichen perforierten Wand als Stützwand 13.

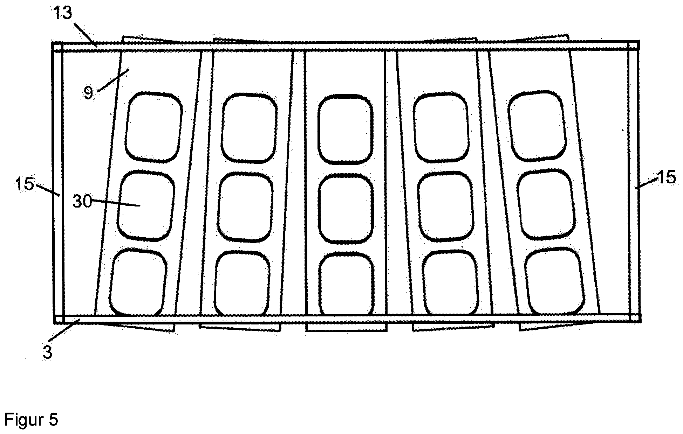

- Figur 5: Haltevorrichtung gemäss einer Ausführungsform der vorliegenden Erfindung mit Verbindungselementen 15 zur Befestigung der Position der Frontwand 3 in Bezug auf die Stützwand 13. Gleichzeitig ist in der Figur 5 eine Anordnung von Stützelementen 9 dargestellt, bei der die Stutzelementen 9 in der Horizontalebene schneidend angeordnet sind und dadurch der Abstand zwischen den Stützelementen in der Horizontalebene hinsichtlich der Bereiche näher der Stützelementen 9, die näher zur Frontabdeckung 3 sind, grösser als hinsichtlich der von der Fronabdeckung 3 entfernten Bereiche der Stützelemente 9.

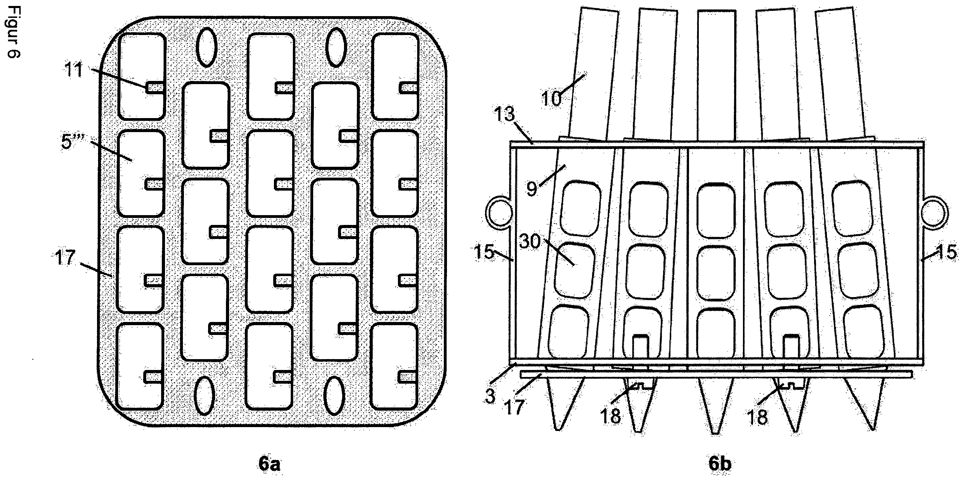

- Figur 6: a) Frontabdeckungsmaske 17 mit einer Anordnung von Öffnungen 5''' und ein Anhaltelement 11 an jeder Öffnung 5"', und b) Haltevorrichtung mit einer Fronabdeckungsmaske 17. In der Haltevorrichtung de Figur 6b ist die Frontabdeckungsmaske 17 an der Frontwand 3 durch Verbindungselemente 18, beispielweise Schrauber, befestigt, so dass die Substratkörper 10 mit Hilfe der Anhaltelemente 11 der Frontabdeckungsmaske 17 derart angehalten werden, dass der Bereich der Substratkörper mit der zu behandelnden Oberfläche aus der Haltevorrichtung durch die Öffnungen 5' gegebenenfalls 5'" herausragt. Der Abstand zwischen der Frontabdeckungsmaske 17 und der Frontwand 13 ist so ausgewählt, dass keine Strahlpartikel, falls beispielsweise die zu behandelnde Oberfläche einer Granulat-Strahl-Oberflächenbehandlung unterzogen ist, zwischen der Frontwand 3 und der Frontabdeckungsmaske 17 gefangen bleiben können.

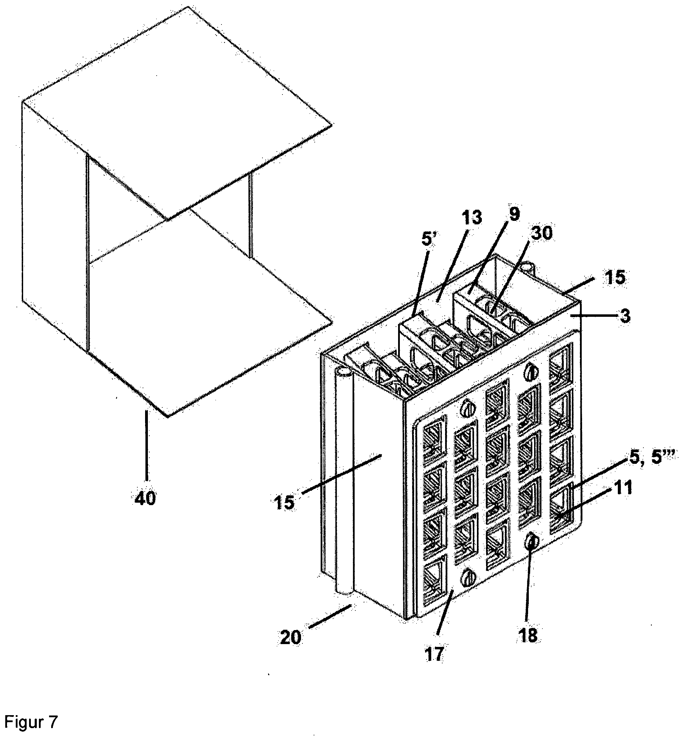

- Figur 7: Haltevorrichtung gemäss einer Ausführungsform der vorliegenden Erfindung mit Verbindungselementen 15 in Form von Wänden, derart dass die Haltevorrichtung in der Form einer Fächerkassette 20 gebaut ist. Zusätzlich ist eine Decke 40 dargestellt, die beispielweise bei einem Beschichtungsprozess dazu dienen soll, dass die nicht zu behandelnden Bereichen der Substratkörper nicht mitbeschichtet werden. Daher wird eine solche Decke 40 im Rahmen der vorliegenden Erfindung insbesondere als Beschichtungsschutzdecke 40 bezeichnet.

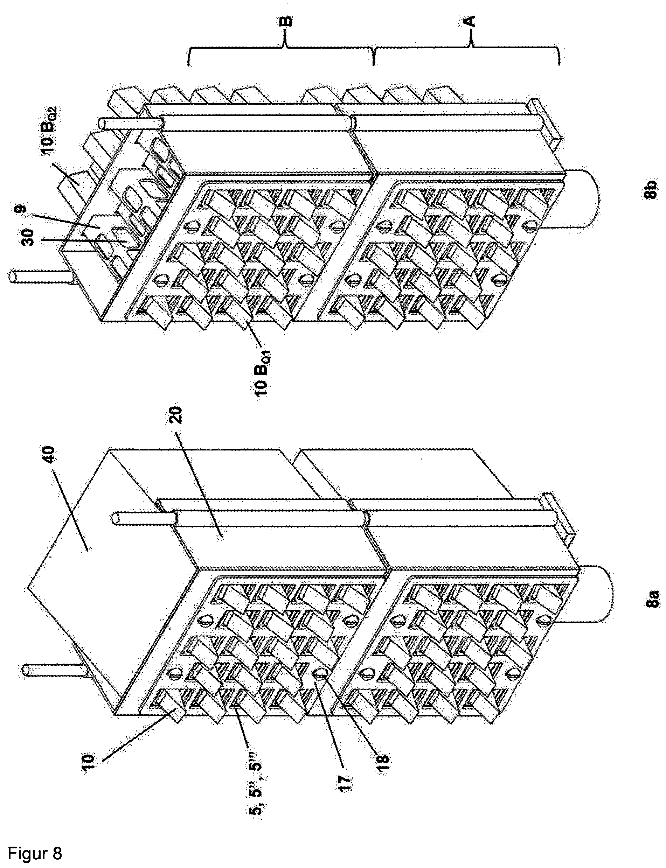

- Figur 8: Haltervorrichtungsanordnung mit 2-Haltevorrichtungen, jede Haltevorrichtung gemäss einer Ausführungsform der vorliegenden Erfindung, eine auf der andere angeordnet, a) mit einer Beschichtungsschutzdecke 40, beispielweise zur Durchführung eines Beschichtungsprozesses, und b) ohne Beschichtungsschutzdecke 40, beispielweise zur Durchführung eines Reinigungs- oder Granulat-Strahl-Prozesses.

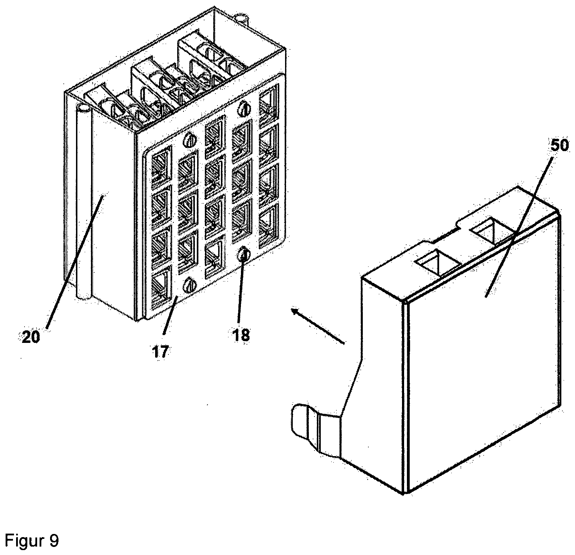

- Figur 9: Haltevorrichtung gemäss einer Ausführungsform der vorliegenden Erfindung mit einer Transportschutzdecke (50).

Die Aufgabe der vorliegenden Erfindung wird gelöst in dem eine Haltevorrichtung mit offener Gestaltung, wie im Anspruch 1 beschrieben, bereitgestellt wird.

Die vorliegende Erfindung betrifft eine Haltevorrichtung (wie die beispielweise in der Figur 2 dargestellte Haltevorrichtung) zur Befestigung von stangenförmigen Substraten 10 (wie das beispielweise in der Figur 1 dargestellte Substrat) mit zumindest zwei Bereichen , B_{Q1} und B_{Q2}, mit unterschiedlichen Querschnitten, Q1 und Q2, wobei ein von den Bereichen ein Ende mit einem Querschnitt kleiner als der Querschnitt des zumindest anderen Bereichs umfasst, z.B. Q1 < Q2, wobei die Haltevorrichtung zumindest eine perforierte Wand umfasst, die mit einer Anordnung von Öffnungen versehen ist und als Frontwand 3 verwendet wird, in die die stangenförmigen Substraten eingesetzt werden können, wobei:
- an jeder Öffnung 5 der Frontwand 3 ein ab der Öffnungsebene nach oben schräggestelltes Stützelement 9 (z.B. ein U-Profil oder ein rechteckiges Profil), vorzugsweise mit einem Neigungswinkel zur Horizontalen α (wie in der Figur 3 dargestellt) grösser als 2°, angeordnet ist, in dem das Substrat zumindest teilweise angeordnet werden kann, und
- an jeder Öffnung 5 der Frontwand 3 zumindest ein Anhaltelement 11 vorhanden ist, um das Substrat an zumindest einer Stelle zwischen dem Bereich mit dem kleinerem Querschnitt B_{Q1} und dem zumindest anderen Bereich B_{Q2} anhalten zu können.

Dabei wird das Substrat in die Haltevorrichtung derart eingesetzt, dass das Ende des Substrats im Bereich mit kleinerem Querschnitt B_{Q1} unter dem anderen Ende des Substrats liegt. Dank diesem Haltevorrichtungsaufbau können die Substrate durch die Stützelemente in die Haltevorrichtung in Richtung Frontwand eingesetzt werden, so dass die Substrate durch die Schwerkraft an die Anhaltelemente gedrückt werden und durch die Anhaltelemente derart angehalten werden, dass zumindest das Ende des Substrats im Bereich mit kleinerem Querschnitt B_{Q1} durch die Öffnung 5 der Frontwand 3 aus der Haltevorrichtung herausragen wird.

Gemäss einer Ausführungsform der vorliegenden Erfindung haben die Stützelemente 9 zwei Enden und zumindest ein Stützelement ist so angeordnet, dass ein Ende des Stützelements auf eine Öffnung 5 der Frontwand 3 gestützt ist (wie in der Figur 2 dargestellt). Vorzugsweise, werden die Stützelemente 9 an die Öffnungen 5 geschweisst.

Eine weitere bevorzugte Variante der Haltevorrichtung gemäss der vorliegenden Erfindung umfasst zumindest eine zweite perforierte Wand, die als Stützwand 13 für die Stützelemente 9 dient. Diese Stützwand 13 ist auch mit einer Anordnung von Öffnungen 5' versehen, durch die die Substrate in die Haltevorrichtung eingesetzt werden können. Die Anordnung von Öffnungen 5' in der Stützwand 13 ist vorzugsweise gleich wie die Anordnung von Öffnungen 5 in der Frontwand 3. Auf diese Weise kann beispielweise das von der Frontwand 3 entfernte Ende des Stützelementes 9 auf eine Öffnung 5' der Stützwand 13 gestützt werden (wie in der Figur 4 dargestellt). Vorzugsweise, ist die Stützwand 13 im Wesentlichen von der Frontwand 3 parallel angeordnet und die Anordnung von Öffnungen 5' der Stützwand 13 liegt zumindest leicht oberhalb jener der Frontwand 3, so dass die Stützelemente 9 in einem Neigungswinkel α zur Horizontalen wie bereits oben erwähnt aufliegen können, und dabei das an der Frontwand 3 angeordnete Ende eines Stützelements 9 unterhalb des an der Stützwand 13 angeordneten Bereichs des Stützelements 9 liegt. Vorzugsweise, werden die Bereiche der Stützelemente 9, die an der Öffnungen 5' der Stützwand 13 angeordnet sind, an die Öffnungen 5' geschweisst.

In einer weiteren bevorzugten Variante einer Haltevorrichtung gemäss der vorliegenden Erfindung sind die Anhaltelemente 11 als Teil einer Frontabdeckungsmaske 17 mit einer Anordnung von Öffnungen 5'" angefertigt (wie beispielsweise in der Figur 6a dargestellt), so dass die Frontabdeckungsmaske an der Frontwand beispielsweise mit Hilfe von Verbindungselementen 18 befestigt werden kann. Die Verbindungselemente 18 können beispielsweise Schrauben sein, die als lösbare Verbindungen dienen können (wie in der Figur 6b dargestellt).

Aufgrund der offenen Gestaltung der Haltevorrichtungen gemäss der vorliegenden Erfindung ermöglichen sie die Reinigung von den in den Haltevorrichtungen gehaltenen Substraten in Reinigungsbädern.

Vorzugsweise wird die Position der Frontwand 3 in Bezug auf die Position der Stützwand 13 in der Haltevorrichtung durch Verbundelemente 15 (wie in der Figur 5 dargestellt) befestigt.

Ausserdem, kann eine solche Haltevorrichtung mit offener Gestaltung gemäss der vorliegenden Erfindung auch zur mechanischen Oberflächenbehandlung von den Teilen der Substrate, die aus der Haltevorrichtung durch die Öffnungen 5, 5'" der Frontwand 3 und Frontabdeckungsmaske 17 herausragen verwendet werden (zumindest das Ende oder die Spitze im Bereich B_{Q1}). Im Sinne von mechanischen Oberflächenbehandlungen ist im Rahmen der vorliegenden Erfindung insbesondere die Durchführung von Granulat-Strahl-Prozessen gemeint.

In einer bevorzugten Variante einer Haltevorrichtung gemäss der vorliegenden Erfindung, die insbesondere zur Reinigung, Beschichtung und weitere Oberflächenbehandlungen wie beispielweise Granulat-Strahlen (z.B. als Vor- und/oder Nachbehandlung der zu beschichtenden Oberfläche) von Schneidwerkzeugen der Sorte Stabmesser gut geeignet ist, können die Verbundelemente 15 Wände sein (wie in der Figur 7 dargestellt), damit es verhindert wird, dass Teile des Körpers der Substrate von den Seiten unerwünscht mitbeschichtet werden. Diese Variante wird im Rahmen der vorliegenden Erfindung Fächerkassette 20 genannt.

Um zu erreichen, dass nur die gewünschten Oberflächen der Substrate bzw. am Beispiel von Stabmessern dann den Spitzenbereich der Substrate (zumindest das Ende im Bereich B_{Q1}) effizient durch physikalische Gasphasenabscheidung beschichtet werden können, wird die Haltevorrichtung gemäss der vorliegenden Erfindung mit einer Beschichtungsschutzdecke 40 ausgestatten, die die Bereiche des Substrates, die nicht durch eine Öffnung 5 der Frontwand 3 herausragen, abschattet. Dadurch wird eine ungewollte Beschichtung von nicht zu beschichtenden Teilen des Körpers des Substrats (die sonst von oben, unten und/oder hinten mitbeschichtet werden können) verhindert.

In der Fächerkassette '20 können die Stabmesser 10 (in Fig. 7 nicht dargestellt) in einer Matrix-Anordnung, wie in Figur 7 dargestellt, als Stabmesserset (z.B. 1 Set ä 16-22 Messer) gestellt werden. Durch einen symmetrischen Aufbau der Haltevorrichtung lässt sich die Frontabdeckungsmaske 17 in vier Positionen montieren und vertikal verschieben, so dass bei jeder Montierungsposition der Frontabdeckungsmaske 17 die Stabmesser an einer verschieden Stelle gehalten werden können. Dadurch lässt sich eine Frontabdeckungsmaske 20 vielfältiger einsetzen und somit kann die gleiche Frontabdeckungsmaske 17, einfach in anderer Position montiert, für die Oberflächenbehandlung von Stabmesser mit anderen Dimensionen und/oder Geometrie verwendet werden.

Der oben erwähnte Inklinationswinkel α der Profile in Bezug auf die Horizontale soll gross genug ausgewählt werden, so dass die Stabmesser sich durch irgendwelchen Vibrationen der Haltevorrichtung nicht nach hinten in Richtung zum hinteren Bereich der Haltevorrichtung bewegen. Jedoch soll der Winkel □ auch nicht so gross ausgewählt werden, dass die zu beschichtenden Oberflächen der Substrate derart abgeschattet werden können, dass die Beschichtung dieser Oberflächen beeinträchtig wird. Beispielweise, in verschiedenen Versionen einer Haltevorrichtung gemäss der vorliegenden Erfindung, hat sich ein Winkel von 5° bis 20° aus der horizontalen (wie im Figur 3 skizziert) als besonders gut geeignet erwiesen.

Die Rechteckprofile 9 wurden "maximal" mit Ausnahmen 30 versehen, wie es beispielsweise in der Figur 6b gezeigt wird, um ein optimales Reinigungsresultat zu erreichen.

Mit dem Ausdruck "maximal mit Ausnahmen 30 versehen" ist es gemeint, dass die Ausnahmen 30" in den in dem dargestellten Fall Rechteckprofilen 9' derart verteilt sind, dass die grösste Fläche der Stabmesser, die in den Rechteckprofilen gehalten werden, freigelegt wird. Zumindest müssen die Profilen mit Ausnahmen so versehen werden, dass zumindest während eines Reinigungsprozesses mehr als 50% der Fläche der Stabmesser direkten Kontakt mit den Reinigungsmitteln haben kann. Vorzugsweise werden die Profile mit Ausnahmen so versehen werden, dass die Profile nicht an mechanische Stabilität derart verlieren, dass sie durch die normale Verwendung der Halterung verformt werden.

Eine weitere Möglichkeit "quasi Rechteckprofile" aufzubauen, die maximal mit Ausnahmen versehen sind, wäre die Verwendung von Profilen, die im Querschnitt statt eine rechteckige Form eine U-Form aufweisen. In diesem Fall würden die U-Profile in der Haltevorrichtung gemäss der vorliegenden Erfindung so positioniert, dass die obere Fläche der in der Haltevorrichtung liegenden Stabmesser komplett frei bleibt.

Ausserdem, wurden der Abstand zwischen der Frontabdeckungsmaske 17 und der Fächerkassette 20 so versehen, dass die Festsetzung von Partikeln aus einem Strahlmittel zwischen der Frontabdeckungsmaske 17 und dem Rest der Fächerkassette 20 verhindert wird. Vorzugsweise ist dieser Abstand ≥ 0.5 mm. Beispielweise, konnten sehr gute Ergebnisse in verschieden Strahlprozessen mit einem Abstand von 0.8 mm erreicht. Man muss aber auch berücksichtigen, dass dieser Abstand nicht so gross sein darf, dass dadurch unerwünschte Oberflächen der Substrate mitbeschichtet werden könnten.

Somit ist die Verwendung einer Haltevorrichtung gemäss der vorliegenden Erfindung auch zur Durchführung von Strahlprozessen, wie z.B. Mikrostrahlen, zur Behandlung der Oberfläche sowohl vor als auch nach der Beschichtung möglich. Dadurch ergibt sich eine gleichbleibende Qualität des kompletten Beschichtungsservices, jedoch ohne den erhöhten Handhabungsaufwand, der bei der Benutzung mehrerer Haltevorrichtungen verursacht wird (das Sortieren der zu behandelnden Substrate, Chargieren in eine erste Haltevorrichtung, Deschargieren, Transportieren, Wiedersortieren, Wiederchargieren in eine zweite Haltevorrichtung usw.). Auch dadurch wird das Risiko die Stabmesser während der Handhabung zu beschädigen vermindert.

Ebenfalls würde die Konstruktion der Fächerkassette 20 so ausgelegt, dass die Stabmesser 10 konisch in einer sphärischen Anordnung angeordnet werden. Dadurch liegen die Stabmesser 10 weiter auseinander, was zu einer gleichmässigeren Schichtverteilung der Beschichtung auf die zu beschichtenden Oberfläche von allen Stabmessern (sowohl von äusseren als auch inneren platzierten Stabmessern) führt (siehe Figur 6b). Mit dieser sphärischen Anordnung der Rechteckprofile, bei der der Abstand zwischen den Stabmessern 10 im hinteren Bereich B_{Q2} verkleinert wird, kann der Abstand zwischen den zu beschichtenden Stabmesser-Spitzen B_{Q1} vergrössert werden, was einen positiven Einfluss auf die Schichtdickenverteilung hat.

Für die Verwendung einer Haltevorrichtung gemäss der vorliegenden Erfindung in einem Vakuumbeschichtungsprozess, bei dem zumindest einem Target als Feststoff-Materialquelle für die Erzeugung der Schicht verwendet wird, wobei beispielweise Stabmessern mit rechteckigem oder ähnlichem Querschnitt beschichtet werden, die zumindest eine zu beschichtende Spanfläche aufweisen, sollen die Stabmesser 10 in den Profilen 9 vorzugsweise so gestellt werden, dass die Spanfläche sich in Richtung Target dreht, um eine höhere Abscheiderate auf den Spanfläche zu ermöglichen und die nicht zu beschichtenden Oberflächen der Stabmesser B_{Q2} soll mit einem Beschichtungsschutz 40 abgedeckt werden (wie in der Figur 7 dargestellt).

Vorzugsweise wird für die Konstruktion einer Haltevorrichtung gemäss der vorliegenden Erfindung ein Material ausgewählt, das die Verwendung der Haltevorrichtung bei allen Prozessschritten nicht beeinträchtigt, zum Beispiel Stahl 1.4301. Dieses Material weist eine genügende mechanische Festigkeit, ist vakuumtauglich, nicht magnetisch, und gegen die bei Reinigungsprozessen eingesetzten Bedingungen (Chemikalien und Temperatuten) resistent.

Behandlungsprozesse wie die Reinigung und das Mikrostrahlen können beispielweise, wie in Figur 8b gezeigt, in zumindest einem Zweierpacket (A + B) durchgeführt werden. Dies reduziert den Aufwand für die Handhabung ebenfalls.

Um die Beschichtung ungewünschter Oberflächenbereichen der Stabmesser, z.B. B_{Q2}, wird die Fächerkassette 20 mit dem Beschichtungsschutz 40, wie in Figur 8b gezeigt, abgedeckt. Auch für die Beschichtung können auch Bäume mit zumindest einem Zweierpacket (A + B), wie auch in Figur 8b gezeigt, konstruiert werden.

Erfindungsgemäss kann man die gleiche Haltevorrichtung für die Durchführung aller Prozessschritte (z.B. Reinigung, Mikrostrahlen oder Granulat-Strahlen, und Beschichtung; eventuell auch Entschichtung, wenn es sich beispielweise um einen chemischen oder elektrochemischen Entschichtungsprozess handelt) verwenden, ohne an Qualität der Behandlung der Oberfläche zu verlieren.

Beim Transport der Substrate von einem Prozessschritt zu anderem in einer Haltevorrichtung gemäss der vorliegenden Erfindung, könnte es jedoch passieren, dass die Bereiche der Substrate, die aus der Halterung herausragen beschädigt werden. Deshalb werden diese Substratbereiche vorzugsweise während des Transports bedeckt werden. Beispielweise kann man dafür eine Transportschutzdecke 50, wie der in der Figur 9 dargestellt, verwenden.

## Patentansprüche

1. Haltevorrichtung zur Befestigung von zumindest einem stangenförmigen Substratkörper (10) mit variablem Querschnitt entlang des Substratkörpers und einer zu behandelnden Oberfläche, die sich in einem Bereich B_{Q1} des Substratkörpers (10) befindet, der ein Ende des Substratkörpers (10) umfasst und einen kleineren Querschnitt als der Rest des Substratkörpers (10) aufweist, wobei die Haltevorrichtung zumindest eine perforierte Wand als Frontwand (3) umfasst, die mit zumindest einer Öffnung (5) versehen ist, **dadurch gekennzeichnet, dass** die Haltevorrichtung zumindest ein Stützelement (9) und ein Anhaltelement (11) umfasst, die an einer Öffnung (5) angeordnet sind, wobei:
- das Stützelement (9) derart gebaut und/oder an der Öffnung (5) befestigt ist, dass der Substratkörper schrägliegend mit einem Neigungswinkel α zur Horizontalen längsseits zumindest zum Teil im Stützelement (9) angeordnet werden kann, und
- das Anhaltelement (11) derart gebaut und/oder an der Öffnung (5) befestigt ist, vorzugsweisse mit Hilfe eines Verbindungselements, dass das Anhaltelement (11) den Substratkörper an einer Stelle zwischen dem Bereich B_{Q1} und dem Rest des Substratkörpers derart anhalten kann, dass der Bereich B_{Q1} durch die Öffnung (5) aus der Haltevorrichtung herausragt, wobei das Ende des Substrats im Bereich mit kleinerem Querschnitt B_{Q1} unter dem anderen Ende des Substrats liegt.

2. Haltevorrichtung gemäss dem Anspruch 1, **dadurch gekennzeichnet, dass** der Neigungswinkel α zur Horizontalen grösser als 2° ist.

3. Haltevorrichtung gemäss zumindest einem der vorhergehenden Ansprüche 1 bis 2, **dadurch gekennzeichnet, dass** das Stützelement (9) länglich ist und zwei Enden aufweist, wobei ein Ende des Stützelements (9) auf die Frontwand (3) gestützt oder an der Frontwand (3) und das andere Ende entfernt von der Frontwand (3) liegt.

4. Haltevorrichtung gemäss dem Anspruch 3, **dadurch gekennzeichnet, dass** die Haltevorrichtung zumindest zwei Stützelemente (9) zur Befestigung von zumindest zwei Substratkörpern (10) umfasst, die in der Vertikalebene parallel und/oder in der Horizontalebene schneidend angeordnet sind, wobei der Abstand in der Horizontalebene zwischen den Stützelementen (9) hinsichtlich der in der Nähe der Frontwand (3) liegenden Bereichen grösser als hinsichtlich der von der Frontwand (3) entfernten Bereichen, dadurch kann ebenfalls der Abstand in der Horizontalebene zwischen den Substratkörpern (10) hinsichtlich der in der Nähe der Frontwand (3) liegenden Bereichen grösser als hinsichtlich der von der Frontwand (3) entfernten Bereichen sein.

5. Haltevorrichtung gemäss zumindest einem der vorhergehenden Ansprüche 3 bis 4, **dadurch gekennzeichnet, dass** die Haltevorrichtung zumindest eine zweite perforierte, von der Frontwand (3) durch einen Abstand entfernte Wand umfasst, die mit zumindest einer Öffnung (5'), (5") versehen ist, und als Stützwand (13) für die Stützelemente (9) in der Haltevorrichtung derart angeordnet ist, dass zumindest ein Teil von einem der Stützelemente (9) sich auf eine Öffnung (5') abstützt.

6. Haltevorrichtung gemäss dem Anspruch 5, **dadurch gekennzeichnet, dass** die Anzahl von Öffnungen in der Anordnung von Öffnungen (5') der Stützwand (13) der Anzahl von Öffnungen in der Anordnung von Öffnungen (5) der Frontwand (3) entspricht, und die Stützwand (13) in die Haltevorrichtung derart angeordnet ist, dass jedes Stützelement (9) sich gleichzeitig auf eine Öffnung (5) und auf eine Öffnung (5') abstützt.

7. Haltevorrichtung gemäss dem Anspruch 6, **dadurch gekennzeichnet, dass** die Stützwand (13) in der Haltevorrichtung hinsichtlich der Frontwand (3) derart parallel angeordnet ist, und/oder die Anordnung von Öffnungen (5') derart entworfen ist, dass
- in der Vertikalebene jede Öffnung der Anordnung von Öffnungen (5') oberhalb der entsprechenden Öffnung der Anordnung von Öffnungen (5) liegt, und/oder
- in der Horizontalebene der Abstand zwischen den Öffnungen der Anordnung von Öffnungen (5') in der Stützwand (13) in der kleiner als der Abstand zwischen den Öffnungen der Anordnung von Öffnungen (5) in der Frontwand (13) ist.

8. Haltevorrichtung gemäss zumindest einem der vorhergehenden Ansprüche 1 bis 7, **dadurch gekennzeichnet, dass** die Anhaltelemente (11) in Form einer Frontabdeckungsmaske (17) mit einer Anordnung von Öffnungen (5"') angefertigt sind, und die Frontabdeckungsmaske (17) an der Frontwand (3) mit Hilfe von Verbindungselementen (18) befestigt ist.

9. Haltevorrichtung gemäss zumindest einem der vorhergehenden Ansprüche 5 bis 8, **dadurch gekennzeichnet, dass** die Haltevorrichtung Verbundelemente (15) umfasst, mit Hilfe von denen die Position der Frontwand (3) in Bezug auf die Position der Stützwand (13) befestigt ist.

10. Haltevorrichtung gemäss dem Ansprüche 9, **dadurch gekennzeichnet, dass** die Verbundelemente (15) Wände sind, die mit dem Rest der Haltevorrichtung eine Fächerkassette (20) bilden.

11. Haltevorrichtung gemäss zumindest einem der vorhergehenden Ansprüche 1 bis 10, **dadurch gekennzeichnet, dass** die Haltevorrichtung mit zumindest einem Substratkörper (10) derart beladen ist, dadurch der Bereich B_{Q1} des Substratkörpers (10) durch eine der Öffnungen (5) der Frontwand (3) aus der Haltevorrichtung herausragt und dadurch auch die zu behandelnde Oberfläche des Substrats.

12. Haltevorrichtung gemäss dem Anspruch 11, **dadurch gekennzeichnet, dass** die Haltevorrichtung eine Decke als Beschichtungsschutzdecke (40) umfasst, die die Bereiche des Substratkörpers (10), die nicht durch die Öffnung (5) der Frontwand (3) herausragen abschattet.

13. Haltevorrichtung gemäss zumindest einem der vorhergehenden Ansprüche 11 bis 12 **dadurch gekennzeichnet, dass** die Haltevorrichtung eine Decke als Transportschutzdecke (50) umfasst, die die Bereiche des Substratkörpers (10), die durch die Öffnung (5) der Frontwand (3) herausragen bedeckt.

14. Methode zur Oberflächenbehandlung von zumindest einem Substratkörper (10), **dadurch gekennzeichnet, dass** die Methode die Durchführung von zumindest einem Oberflächenbehandlungsprozess umfasst, bei dem der Substratkörper (10) sich in einer Haltevorrichtung gemäss zumindest einem der vorhergehenden Ansprüche 11 bis 13 befindet.

15. Methode gemäss dem Anspruch 14, **dadurch gekennzeichnet, dass** die Methode zumindest einem der folgenden Prozessschritte a. bis d. umfasst:
a. Reinigung der Substratkörper, beispielweise in einer Reinigungsbad,
b. Vorbehandlung der zu behandelnden Oberfläche der Substratkörper, beispielweise bei einem Granulat-Strahl-Prozess,
c. Beschichtung der zu behandelnden Oberfläche der Substratkörper bei einem Beschichtungsprozess.
d. Nachbehandlung der zu behandelnden Oberfläche der Substratkörper,
wobei die Substratkörper erstens sortiert und in eine Haltevorrichtung gemäss zumindest einem der vorhergehenden Ansprüche 1 bis 11 chargiert werden, und :
- die Substratkörper sich immer in der gleichen Haltevorrichtung befinden, so dass kein Deschargieren und Wiederchargieren aus der und in die Haltevorrichtung zwischen den Prozessschritten notwendig ist,
- die Substratkörper in der gleichen Haltevorrichtung von einem zum anderem Prozessschritt transportiert werden,
- gegebenenfalls für die Durchführung des Beschichtungsprozesses, die nicht zu behandelnden Oberflächen der Substratkörper, die durch die Frontwand (3) aus der Haltevorrichtung nicht herausragenden mit einer Beschichtungsschutzdecke (40) gemäss dem Anspruch 12 derart abgeschattet werden, dass eine Beschichtung der nicht zu behandelnden Oberflächen vermieden wird.

## Claims

1. Holding device for fixing of at least one rod-shaped body (10) of a substrate having a variable cross section along the body and a surface to be treated, which is located in an area B_{Q1} of the body (10) comprising an end of the body (10) and has a cross section which is smaller than the rest of the body (10), whereby the holding device comprises at least one perforated wall as a front wall (3)which is provided with at least one opening (5), **characterized in that** the holding device comprises at least one support element (9)and a stop element (11) which are arranged at an opening (5), thereby:
- The support element (9) is built in such a way and/or attached to the opening (5), that the body can be arranged oblique with an inclination α to the horizontal line and at least in part within the support element (9) and
- the stop element (11) is built in such a way and/or attached to the opening (5), preferably by means of a connecting element, that the stop element (11) can stop the body in a position between area B_{Q1} and the rest of the body in such a way, that the area B_{Q1} protrudes from the holding device, whereby the end of the substrate in the sector with smaller cross section B_{Q1} is situated under the other end of substrate.

2. Holding device according to claim 1, **characterized in that** inclination α to the horizontal line is bigger than 2°.

3. Holding device according to one of the previous claims 1 to 2, **characterized in that** the support element (9) has an elongated shape and two ends, whereby one end of the support element (9) is based on the front wall (3) or is at the front wall (3) and the other end is remote from the front wall (3).

4. Holding device according to claim 3, **characterized in that** the holding device comprises at least two support elements (9) for fixation of at least two substrate bodies (10) which are arranged in parallel in the vertical plain and/or crossing with reference to the horizontal plain, whereby the distance between support elements (9) in the horizontal plain is wider with reference to the areas being located near the front wall (3) than to areas remote from the front wall (3), which also the distance between substrate bodies (10) in the horizontal plain can be wider with reference to the areas near to the front wall (3) than with areas remote from the front wall.

5. Holding device according to one of the previous claims 3 or 4, **characterized in that** the holding device comprises at least a second perforated wall which is remote from the front wall (3) by a distance, which is provided with at least one opening (5'), (5") and is arranged as support wall (13) for the support elements (9) in the holding device in such a way that at least a part from one of the support elements (9) is supported simultaniously by an opening (5) and an opening (5').

6. Holding device according to claim 5, **characterized in that** the number of openings in the arrangement of openings (5') of the support wall (13) corresponds to the number of openings in the arrangement of openings (5) in the front wall (3), and support wall (13) in the holding device is configured such that each support element (9) supports itself simultaneously to one opening (5) and to one opening (5').

7. Holding device according to claim 6, **characterized in that** the support wall (13) is arranged within the holding device with reference to the front wall (3) in such a way in parallel and/or the arrangement of opening (5') is designed in such a way that
- each opening of the arrangement of openings (5") is positioned above the openings of the arrangement of openings (5) with reference to the vertical plain and/or
- Distance between openings of the arrangement of openings (5') in the support wall is smaller than the distance between the openings of the arrangement of openings (5) in the front wall (13) with reference to the horizontal plain.

8. Holding device according to one of the previous claims 1 to 7, **characterized in that** the stop elements (11) are made in the shape of a front cover mask (17) with an arrangement of openings (5''') and front cover mask (17) is attached to the front wall (3) with fasteners (18).

9. Holding device according to one of the previous claims 5 to 8, **characterized in that** the holding device comprises connecting elements (15) which are made to fix the position of the front wall (3) with reference to the position of the support wall (13).

10. Holding device according to claim 9, **characterized in that** the connecting elements (15) are walls which form a fancassette (20) with the other elements of the holding device.

11. Holding device according to one the previous claims 1 to 10, **characterized in that** the holding device is charged with substrate bodies (10) in such a way that area B_{Q1} of the substrates bodies (10) protrudes from an opening (5) of the front wall (3) from out of the holding device and thereby also do the substrate surfaces to be treated.

12. Holding device according to claim 11, **characterized in that** the holding device comprises a cover formed as coating protection cover (40) which covers areas of the substrate bodies (10) which do not protrude trough opening (5) of the front wall (3).

13. Holding device according to at least on the previous claims 11 to 12, **characterized in that** the holding device comprises a cover as transport protection cover (50) which covers areas of the substrate bodies (10) which protrude trough opening (5) of the front wall (3).

14. Method for a surface treatment of at least one substrate body (10), **characterized in that** the method comprises at least one surface treatment process, whereby the substrate body (10) is located in a holding device according to at least one of the previous claims 11 to 13.

15. Method according to claim 14, **characterized in that** the method comprises at least one of the following process steps a. to d.:
a. cleaning of the substrate body, e.g. within a cleaning solution,
b. pre-treatment of the surface to be treated of the substrate body, e.g. by a granulate blasting process,
c. coating of the surface to be treated of the substrate body by a coating process,
d. post-treatment of the surface to be treated of the substrate body,whereby substrate bodies are first sorted and charged into a holding device according to at least one of the previous claims 1 to 11 and:
- Substrate bodies are always in the same holding device, such that no charging and re-charging from and into the holding device has to be done between the process steps,
- Substrate bodies can be transported in the same holding device from one process step to the other,
- Where if applicable for the accomplishment of the coating process surfaces of the substrate bodies which have not to be treated and do not protrude trough front wall (3) from the holding device are covered with a coating protection cover (40) according to claim 12 in such a way that coating of the not to be treated surfaces is avoided.

## Revendications

1. Dispositif de retenue pour fixer au moins un corps de substrat (10) en forme de barre, à section transversale variable le long dudit corps de substrat, et dont une zone B_{Q1} du corps de substrat (10) présente une surface à traiter, laquelle zone comprend une extrémité du corps de substrat (10) et présente une section transversale plus petite que le reste du corps de substrat (10), le dispositif de retenue comprenant au moins une paroi perforée comme paroi avant (3), laquelle étant munie d'au moins une ouverture (5), **caractérisé en ce que** le dispositif de retenue comprend au moins un élément d'appui (9) et un élément de retenue (11) agencés au niveau d'une ouverture (5), dans lequel :
- l'élément d'appui (9) est conçu et/ou fixé à l'ouverture (5) de sorte que le corps de substrat peut être agencé au moins en partie dans l'élément d'appui (9) incliné sur la longueur à un angle d'inclinaison α par rapport à l'horizontale, et
- l'élément de retenue (11) est conçu et/ou fixé à l'ouverture (5), de préférence à l'aide d'un élément de liaison, de sorte que l'élément de retenue (11) peut retenir le corps de substrat en un point situé entre la zone B_{Q1} et le reste du corps de substrat, afin que la zone B_{Q1} fasse saillie hors du dispositif de retenue par l'ouverture (5), l'extrémité du substrat dans la zone de section transversale inférieure B_{Q1} étant sous l'autre extrémité du substrat.

2. Dispositif de retenue selon la revendication 1, **caractérisé en ce que** l'angle d'inclinaison α par rapport à l'horizontale est supérieur à 2°.

3. Dispositif de retenue selon au moins l'une des revendications précédentes 1 à 2, **caractérisé en ce que** l'élément d'appui (9) est oblong et comprend deux extrémités, une extrémité de l'élément d'appui (9) étant appuyée sur la paroi avant (3) ou au niveau de la paroi avant (3) et l'autre extrémité étant éloignée de la paroi avant (3).

4. Dispositif de retenue selon la revendication 3, **caractérisé en ce que** le dispositif de retenue comprend au moins deux éléments d'appui (9) pour fixer au moins deux corps de substrat (10), lesquels éléments sont agencés parallèles dans le plan vertical et/ou se coupant dans le plan horizontal, la distance dans le plan horizontal entre les éléments d'appui (9) par rapport aux zones situées à proximité de la paroi avant (3) étant plus grande que par rapport aux zones éloignées de la paroi avant (3), de sorte que la distance dans le plan horizontal entre les corps de substrat (10) par rapport aux zones situées à proximité de la paroi avant (3) peut également être plus grande que par rapport aux zones éloignées de la paroi avant (3).

5. Dispositif de retenue selon au moins l'une des revendications précédentes 3 à 4, **caractérisé en ce que** le dispositif de retenue comprend au moins une deuxième paroi perforée éloignée d'une certaine distance de la paroi avant (3), cette deuxième paroi étant munie d'une ouverture (5'), (5") et étant agencée comme paroi d'appui (13) pour les éléments d'appui (9) dans le dispositif de retenue de sorte qu'au moins une partie des éléments d'appui (9) s'appuie sur l'ouverture (5').

6. Dispositif de retenue selon la revendication 5, **caractérisé en ce que** le nombre d'ouvertures dans l'agencement d'ouvertures (5') de la paroi d'appui (13) correspond au nombre d'ouvertures dans l'agencement d'ouvertures (5) de la paroi avant (3), et **en ce que** la paroi d'appui (13) est agencée dans le dispositif de retenue de sorte que chaque élément d'appui (9) vienne s'appuyer en même temps sur une ouverture (5) et sur une ouverture (5').

7. Dispositif de retenue selon la revendication 6, **caractérisé en ce que** la paroi d'appui (13) est agencée dans le dispositif de retenue parallèlement à la paroi avant (3) et/ou **en ce que** l'agencement des ouvertures (5') est conçu de sorte que
- dans le plan vertical, chaque ouverture de l'agencement d'ouvertures (5') soit située au-dessus de l'ouverture correspondante de l'agencement d'ouvertures (5), et/ou
- dans le plan horizontal, la distance entre les ouvertures de l'agencement d'ouvertures (5') dans la paroi d'appui (13) soit inférieure à la distance entre les ouvertures de l'agencement d'ouvertures (5) dans la paroi avant (13).

8. Dispositif de retenue selon au moins l'une des revendications précédentes 1 à 7, **caractérisé en ce que** les éléments de retenue (11) sont conçus sous la forme d'un cache de recouvrement avant (17) avec un agencement d'ouvertures (5"'), et **en ce que** le cache de recouvrement avant (17) est fixé à la paroi avant (3) à l'aide d'éléments de liaison (18).

9. Dispositif de retenue selon au moins l'une des revendications précédentes 5 à 8, **caractérisé en ce que** le dispositif de retenue comprend des éléments de liaison (15) à l'aide desquels la position de la paroi avant (3) est fixée par rapport à la position de la paroi d'appui (13).

10. Dispositif de retenue selon la revendication 9, **caractérisé en ce que** les éléments de liaison (15) sont des parois qui forment avec le reste du dispositif de retenue un coffret (20).

11. Dispositif de retenue selon au moins l'une des revendications précédentes 1 à 10, **caractérisé en ce que** le dispositif de retenue est chargé avec au moins un corps de substrat (10) de sorte que la zone B_{Q1} du corps de substrat (10) fait saillie hors du dispositif de retenue par l'une des ouvertures (5) de la paroi avant (3), de même que la surface à traiter du substrat.

12. Dispositif de retenue selon la revendication 11, **caractérisé en ce que** le dispositif de retenue comprend un couvercle comme couvercle de protection (40) qui protègent les zones du corps de substrat (10) qui ne sortent pas par l'ouverture (5) de la paroi avant (3).

13. Dispositif de retenue selon au moins l'une des revendications précédentes 11 à 12, **caractérisé en ce que** le dispositif de retenue comprend un couvercle comme couvercle de protection de transport (50) qui recouvre les zones du corps de substrat (10) qui sortent par l'ouverture (5) de la paroi avant (3).

14. Procédé de traitement de surface d'au moins un corps de substrat (10), **caractérisé en ce que** le procédé consiste à réaliser au moins un processus de traitement de surface, dans lequel le corps de substrat (10) se trouve dans un dispositif de retenue selon au moins l'une des revendications précédentes 11 à 13.

15. Procédé selon la revendication 14, **caractérisé en ce que** le procédé comprend au moins l'une des étapes suivantes a à d :
a. nettoyage des corps de substrat, par exemple dans un bain de nettoyage,
b. traitement préalable des surfaces à traiter des corps de substrat, par exemple lors d'un procédé de pulvérisation de granulats,
c. revêtement des zones à traiter des corps de substrats dans un processus de revêtement,
d. traitement postérieur des surfaces à traiter des corps de substrat,
les corps de substrat étant d'abord triés et chargés dans un dispositif de retenue selon au moins l'une des revendications précédentes 1 à 11, et :
- les corps de substrat se trouvant toujours dans le même dispositif de retenue, de sorte qu'aucun déchargement et rechargement du dispositif de retenue n'est nécessaire entre les différentes étapes,
- les corps de substrat étant transportés dans le même dispositif de retenue d'une étape à l'autre,
- le cas échéant pour la réalisation du processus de revêtement, les surfaces n'étant pas à traiter des corps de substrat qui ne sortent pas du dispositif de retenue par la paroi avant (3) étant protégées par un couvercle de protection (40) selon la revendication 12, de façon à éviter un revêtement des surfaces qui ne sont pas à traiter.
